Europäisches Patentamt

European Patent Office

Office européen des brevets

(19)

(11) **EP 0 788 681 B1**

(12) **EUROPÄISCHE PATENTSCHRIFT**

(45) Veröffentlichungstag und Bekanntmachung des Hinweises auf die Patenterteilung:
**23.09.1998 Patentblatt 1998/39**

(21) Anmeldenummer: **95934611.5**

(22) Anmeldetag: **17.10.1995**

(51) Int Cl.[6]: **H03K 3/0231**

(86) Internationale Anmeldenummer:
**PCT/DE95/01439**

(87) Internationale Veröffentlichungsnummer:
**WO 96/13899 (09.05.1996 Gazette 1996/21)**

(54) **STEUERBARER OSZILLATOR**

CONTROLLABLE OSCILLATOR

OSCILLATEUR CONTROLABLE

(84) Benannte Vertragsstaaten:
**DE FR GB IT PT SE**

(30) Priorität: **28.10.1994 DE 4438670**

(43) Veröffentlichungstag der Anmeldung:
**13.08.1997 Patentblatt 1997/33**

(73) Patentinhaber:
• **SIEMENS AKTIENGESELLSCHAFT**
  **80333 München (DE)**
• **SGS-THOMSON MICROELECTRONICS GMBH**
  **85630 Grasbrunn (DE)**

(72) Erfinder:
• **BRAKUS, Bogdan**
  **D-82131 Stockdorf (DE)**
• **ROTH, Heinz-Jürgen**
  **D-80469 München (DE)**

(56) Entgegenhaltungen:
**EP-A- 0 407 269    GB-A- 2 090 091**
**US-A- 4 233 575**

• **RADIO FERNSEHEN ELEKTRONIK, Bd. 38, Nr. 1, 1989 BERLIN DE, Seiten 8-12, JÜNGLING 'Spannungsgesteuerter Funktionsgenerator IA 338 D'**

**Beschreibung**

Die Erfindung bezieht sich auf eine, wie im Oberbegriff des Patentanspruchs 1 angegebene Schaltungsanordnung eines steuerbaren Oszillators.

Eine derartige Schaltungsanordnung ist beispielsweise aus The Macrochip, Designmanual, 1987, Ferranti Interdesign, Inc. Scotts Valley, California, Seite 1 Triangle Oscillator, Gridded array macro MM 14001 bekannt. Diese Schaltungsanordnung weist jedoch den Nachteil einer zunehmenden Ungenauigkeit zwischen einer frequenzeinstellenden Stellgröße und einer erwarteten Oszillatorfrequenz, insbesondere bei geringen und hohen Frequenzen auf. Eine derartige Schaltung ist ebenfalls aus RADIO FERNSEHEN ELEKTRONIK, Band 38, Nr. 1, 1989, Berlin, Seiten 8-12 bekannt.

Aufgabe der Erfindung ist es, einen spannungsgesteuerten Oszillator so auszubilden, daß er für einen großen Frequenzbereich geeignet ist.

Gemäß der Erfindung wird ein spannungsgesteuerter Oszillator zur Lösung dieser Aufgabe in der im kennzeichnenden Teil des Patentanspruchs 1 angegebenen Weise ausgebildet.

Die Erfindung weist den Vorteil auf, daß die Oszillatorfrequenz beeinflussenden Ströme ausschließlich zum Laden und Entladen der Speichereinheit des Oszillators verwendet werden und der Oszillator besonders zur Erzeugung von sehr großen und extrem kleinen Folgefrequenzen geeignet ist.

Ein weiterer Vorteil der Schaltungsanordnung ist, daß mit Verringerung der Folgefrequenz der Stromverbrauch der angegebenen Schaltungsanordnung abnimmt und sich ein günstiger Wirkungsgrad bei geringer Leistungsanforderung ergibt.

Die Schaltungsanordnung weist den weiteren Vorteil auf, daß die Folgefrequenz in sehr weiten Bereichen einstellbar ist.

Ein weiterer Vorteil der Schaltungsanordnung ist es, daß diese in einem integrierten Schaltkreis ausführbar ist und sehr wenig externe Komponten benötigt.

Ein weiterer Vorteil der Schaltungsanordnung ist, daß diese temperaturkompensiert ist und im ungesättigten Betrieb arbeitet, wodurch sich eine große Frequenzstabilität ergibt.

Weitere Besonderheiten der Erfindung werden aus der nachfolgenden näheren Erläuterung eines Ausführungsbeispiels anhand von Zeichnungen ersichtlich.

Es zeigen :

Fig. 1    eine schematische Darstellung eines Oszillators,
Fig. 2    ein Ausgestaltung des Oszillators und
Fig. 3,4    eine Detaildarstellung des Oszillators.

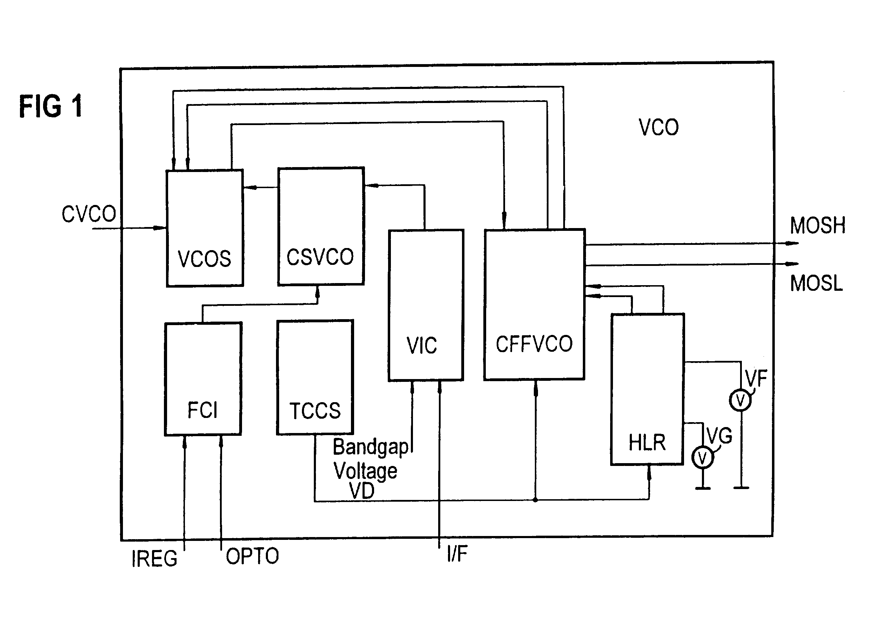

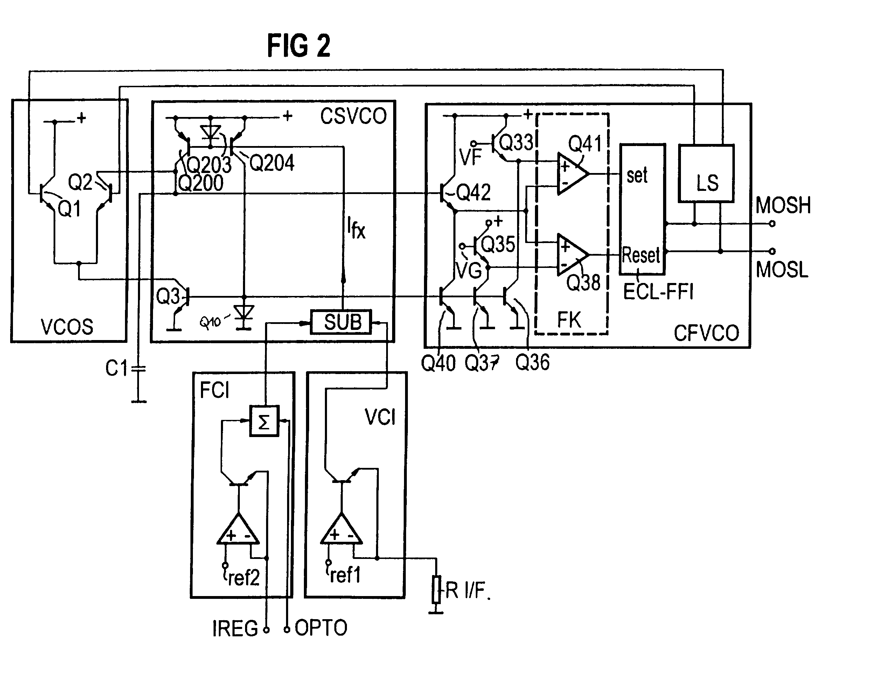

Anhand des Blockschaltbildes in Figur 1 und einer vereinfachten Schaltungsausführung, wie sie in Figur 2 dargestellt ist, soll nachfolgend der Gegenstand der Erfindung erläutert werden. Diese Schaltungsanordnung eignet sich insbesondere zur Ansteuerung eines elektronischen Schalters der im Hauptstromkreis eines Umrichters angeordnet sein kann.

Im einzelnen sind in Figur 1 folgende Schaltkreise in diesem steuerbaren Oszillator VCO angeordnet:

FCI:    Frequency Control Input,
VCOS:    VCO-Switch,
CSVCO:    Current Source VCO,
TCCS:    Temperature Compensated Current Source,
VIC:    Voltage to Current Converter,
CFFVCO:    Komparator CO, ECL-Flip-Flop ECL-FF1,
HLR:    High/LOW Reference.

Einzelne Schaltkreise sind mit Steueranschlüssen versehen. Über diese Steueranschlüsse ist die Frequenz des Ausgangssignals des steuerbaren Oszillators beeinflußbar.

CVCO: Kondensatoranschluß von CI zur Bestimmung der maximalen Taktfrequenz,
IREG: Stelleingang zur Reduzierung der Frequenz mit eingestellter interner Schwelle durch die mit ref1 bezeichnete Referenzspannung,
OPTO: Stromstelleingang zur Reduzierung der Frequenz I/F: Einstellung der Maximalfrequenz in Verbindung mit dem am Anschluß CVCO angeschlossenen Kondensator.

Mit der in der schematischen Darstellung in Fig. 1 gezeigten Schaltungsausprägung ist es möglich mit kleinen Leistungen und hohen Frequenzen zu arbeiten und über weite Bereiche die Frequenz zu ändern. So zum Beispiel wurden schnelle Transistoren mit einer 6 GHz Transitfrequenz eingesetzt, wobei die Transistoren im ungesättigtem Betrieb arbeiten. Dies bringt den Vorteil mit sich, daß der Leistungsverbrauch der Schaltungsanordnung bei hoher Schaltfrequenz geringgehalten wird. Um die Frequenz in einem weiten Bereich zu ändern und temperaturunabhängig zu machen, wird mit über mehrere Dekaden veränderbaren temperaturkompensierten Strömen gearbeitet. Um Speicher- und Steuerfunktionen auszuführen wird ein Kontrollschaltungsteil ECL-FF1 im VCO verwendet, das mit konstanten differentiellen Pegeln arbeitet. Um bei Verringerung der Frequenz eine Anpassung der Eingangsströme des Kontrollschaltungsteiles zu erreichen, wird dessen Eingangsimpedanz ständig angepaßt.

Fig. 2 zeigt eine zum Verständnis der Erfindung vereinfachte Schaltungsausführung.

Nachfolgend wird die Schaltungsanordnung für den Fall beschrieben das keine Stellanforderung an den Stelleingängen OPTO und IREG anliegt.

Da keine Stellanforderung an den Stelleingängen anliegt, liefert der Oszillator VCO ein Ausgangssignal mit maximaler Frequenz VCOfmax. Die maximale Frequenz wird durch einen Kondensator C1, einen Widerstand R I/F sowie einer oberen Potentialschwelle, vorgegeben durch eine erste Referenzspannung VF und einer unteren Potentialschwelle, vorgegeben durch eine zweite Referenzspannung VG bestimmt. Der maximale Stellstrom wird am Stromspiegel Q203 I/Fmax gespiegelt

Über den als Differenzstufe Q1, Q2 ausgebildeten Schalter VCOS wird der Kondensator C1 über den als Stromquelle wirkenden Transistor Q200 aufgeladen und über den als Stromquelle wirkenden Transistor Q3 entladen. Die Stromquellen Q200 und Q3 werden so gewählt, daß sich am Kondensator C1 eine Dreiecksschwingung mit gewünschter Periodendauer einstellt. Über einen Impedanzwandler Q42 wird das am Kondensator C1 anliegende Spannungspotential an den Vergleichereingang eines aus zwei Komparatoren Q41, Q38 gebildeten Fensterkomparators FK weitergeleitet. Der Fensterkomparator FK vergleicht das am Kondensator C1 anliegende Spannungspotential mit der am Komparator Q41 anliegenden ersten Referenzspannung VF oder mit der an dem zweiten Komparator anliegenden zweiten Referzspannung VG.

Die Ausgangssignale des Fensterkomparators Q41, Q38 bewirken ein Set bzw. Reset an einem Flip-Flop ECL-FF1. Über die Schalteinheit Level-Shift LS gebildet mit den Transistoren Q45...Q50 wird über den Schalter Q1, Q2 bei Erreichen der ersten oder zweiten Referenzspannung VF, VG der Ladevorgang oder Entladevorgang des Kondensators C1 beendet und der Entladevorgang oder Ladevorgang begonnen. Der Ausgang des Flip-Flops ECL-FF1 liefert ebenso die ECL Ausgangssignale MOSH, MOSL der Gesamtschaltung des steuerbaren Oszillators VCO. Mit diesem Ausgangssignal MOSH, MOSL kann beispielsweise ein in einem Hauptstromkreis eines Umrichters angeordneter Schalter, ein Power-MOS Transistor, angesteuert werden.

Nachfolgend wird die Funktion der Schaltung beschrieben wenn durch Stellanforderungen über die Anschlüsse IREG oder OPTO die Frequenz des Ausgangssignals des spannungsgesteuerten Oszillators VCO beeinflußt werden soll. Die beiden Stellströme werden in der Schalteinheit FCI zusammengefaßt. Der maximal mögliche Stellstrom I Fmax wird jeweils um die Summe der Stellströme IREG, OPTO reduziert (Q208, Q70 und Stromspiegel Q203). Die Periodendauer der Dreiecksschwingung, die von diesem Strom abhängig ist, verringert sich ebenfalls propotional zur Stromverminderung.

Da die Dreiecksspannung am Kondensator C1 über einen Fensterkomparator FK mit oberer und unterer Schwelle (erster und zweiter Referenzspannung) VF, VG abgefragt wird, würde die Eingangsimpedanz des Fensterkomparators FK eine Vergrößerung der Periodendauer begrenzen, da der Eingangsstrom des Fensterkomparators FK in dem Bereich des Auf- und Entladestromes von C1 kommen würde. Um dies zu vermeiden wird der Eingangswiderstand von der Q41/Q38 ständig der Arbeitsfrequenz des VCO über Q42/Q40, Q33/Q36, Q35/Q37 angepaßt.

Die Anpassung der Eingangsimpedanz erfolgt über die Stromabfrage des VCO, indem über Q10 gleichzeitig ein Ist-Strom zur Frequenzstellung des spannungsgesteuerten Oszillators VCO auch dem Impedanzwandler des Fensterkomparators FK zuführt wird. Dies hat den Vorteil, daß für große Ist-Ströme des VCO die Impedanzwandlerstufe wegen des somit großen Spiegelstromes, Q40, Q37, Q36 schnell ist und anderseits für kleine Ist-Ströme des VCO der Basisstrom in Q42 entsprechend reduziert ist. Damit stellt der Basisstrom von Q42 über die Frequenzstellung des VCO betrachtet eine ebenfalls proportionale Größe in weiten Bereichen dar, da der Emitterstrom von Q42 direkt aus der Ist-Strom-Stellgröße gewonnen wird.

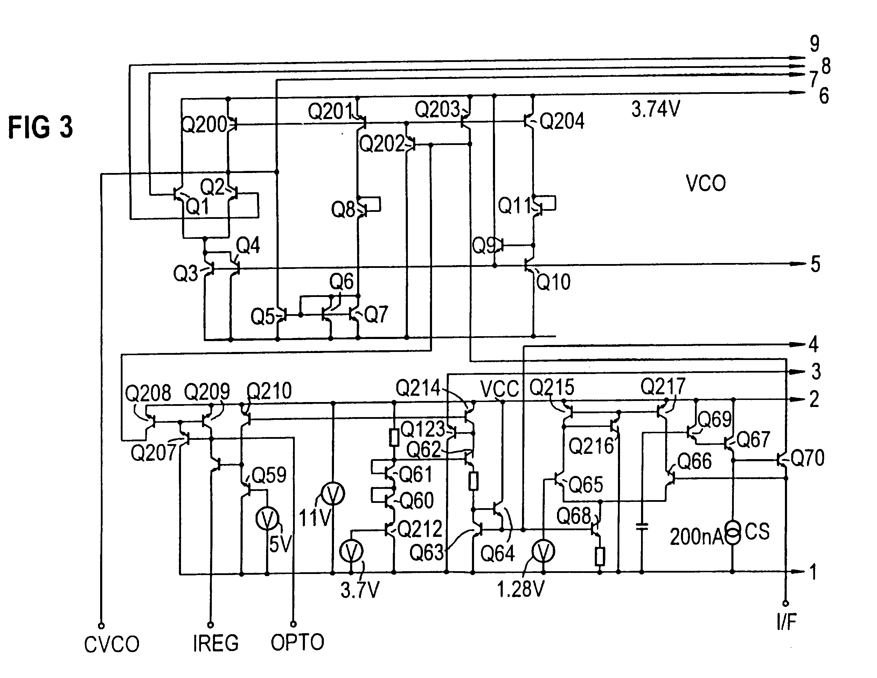

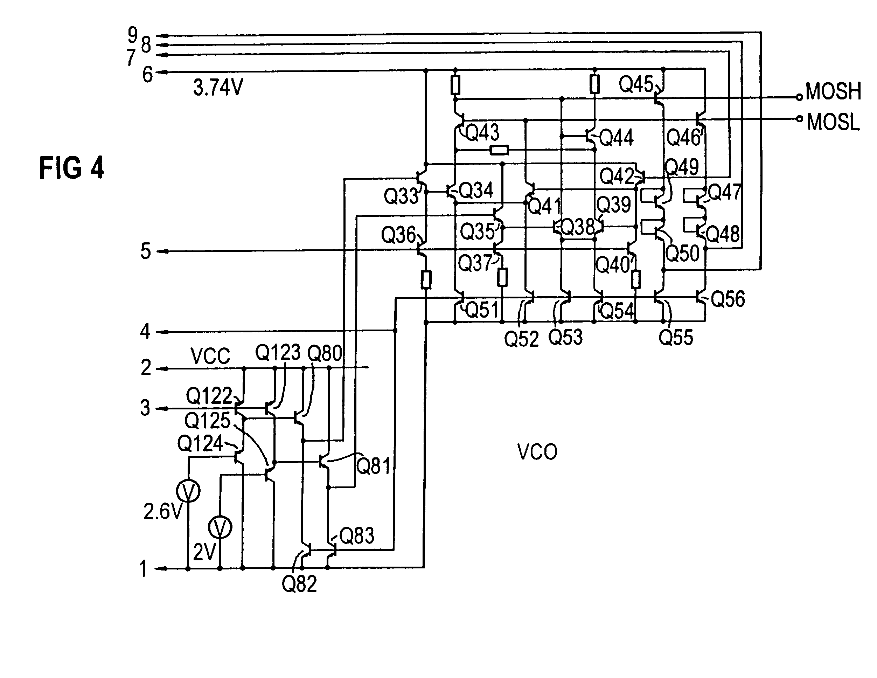

In Fig. 3 und 4 ist eine detaillierte Schaltungsanordnung der in Fig. 2 gezeigten vereinfachten Darstellung wiedergegeben. Die Funktionsweise der Schaltungsanordnung ist nachfolgend beschrieben:
Am Anschluß I/F der Schaltkomponente VIC wird über die Transistoren Q70, Q71 eine Spannungs-Stromwandlung vorgenommen. Durch eine Bufferschaltung gebildet durch die Transistoren Q65 ... Q71, Q215 ... Q217 und die Spannungsquelle VD, die als Band-Gap ausgebildet ist, wird erreicht, daß der durch die Transistoren Q70, Q71 extrahierte Strom, temperaturunabhängig ist und sich dadurch die Frequenz über den Temperaturbereich nicht ändert.

Der Strom, der im Kollektor von Q70 fließt wird dem Stromspiegel von CSVCO Q200 ... Q204 zugeführt. Die Transistoren Q200 ... Q204 bilden mit Q3 ... Q11 den Stromgenerator für den frequenzvariablen Betrieb.

Über den VCOS, der durch die Transistoren Q1, Q2 gebildet ist, erfolgt die Umladung von CSVCO. An den Basen der Transistoren Q1, Q2 liegt eine differentielle Spannung an. Je nach Aussteuerung der Basen wird CSVCO über Q200 aufgeladen oder über Q3, Q4 entladen, da der Entladestrom, der in Q 204 generiert wird, im Verhältnis 2 : 1 (Transistoren Q9, Q10, Q3, Q4) gespiegelt wird. Der Verlauf der Spannung des CSVCO ist dreieckförmig. Die Größe der Dreiecksamplitude, die sich im CSVCO ergibt, wird durch die Referenzspannungen VF und VG festgelegt, welche über die Transistoren Q124, Q122, Q80 bzw. Q125, Q123, Q81 dem VCO (Komparator CO/ECL-Flip-Flop-Frequenz) zugeführt werden. Über Q33 und Q35 liegen die Referenzspannungen an dem Komparator, ECL-Flip-Flop/Frequenz, welcher über Q42 die Spannung am VCO mit diesen Referenzoder Schwellspannungen VF, VG vergleicht. Erreicht VCOS den oberen oder unteren Wert der Referenzspannung, erfolgt über Q41 bei Erreichen von VF-reset oder bei Erreichen von VG über Q38-set an dem Flip-Flop Q43, Q44. An den Flip-Flop Transistoren Q43, Q44 ergibt sich durch die Wahl des Stromes in den Stromquellen Q51, Q52, Q53, Q54 und den Kollektorwiderstanden von 3,3 K ein differentielles Signal von 320mV, welches über Q45 ... Q50 den Schalter Q1, Q2 im VCOS umschaltet.

Die Besonderheit der bisher beschriebenen Schaltkreise ergibt sich aus dem Aufbau der Eingangsschaltung, die über Q36, Q37, Q40 den Strom aus dem Stromspiegel Q9, Q10 in die Eingangsstufen des Komparators spiegelt. Hier ergibt sich der Vorteil, daß der Eingangsstrom an der Basis von Q42 vom Strom im VCO-Umschalter Q1, Q2 abhängig gemacht wird und somit bei einer Frequenzvariation am Anschluß VCO im Verhältnis 1:100 sich dieser Basisstrom um das gleiche Verhältnis verändert, wodurch die Darlingtonstufe Q42, Q39, Q41 in der Geschwindigkeit der VCO-Frequenz angepaßt wird.

Da die Stromquellen Q51 ... Q56 mit dem fest eingestellten Strom arbeiten, ist durch die Darlington-Eingangstransistoren Q33/Q34, Q35/Q38, Q42/Q41, Q42/Q39 die Impedanzanpassung an den VCO-Strom und die Umsetzung in konstante ECL-Pegel in den Kollektoren Q43, Q44 möglich.

Die Frequenzeinstellung erfolgt dabei durch folgende Schaltungsausgestaltung: Bei den im Schaltungsbeispiel ausgeführten Spiegelverhältnis der Transistoren, ist die Maximalfrequenz des VCO durch den eingestellten Strom am Anschluß I/F, der Größe der Amplitude, der Dreiecksspannungshub VF - VG und die Größe des Kondensators am Anschluß VCO bestimmbar. Die Zeiten t1, t2 mit denen die Frequenz des VCO bestimmt werden kann, können wie nachfolgend aufgeführt errechnet werden:

$$t1 = \frac{C_{VCO} \cdot 0.6}{\frac{1.26}{R_{IF} \cdot 2}} [s] \tag{1}$$

$$t2 = \frac{C_{VCO} \cdot 0.6}{\frac{1.26}{R_{IF} \cdot 2} \cdot 0.774} [s] \tag{2}$$

die Frequenz des VCO:

$$f_{VCO} = \frac{1}{t1 + t2} = \frac{0.458}{C_{VCO} \cdot R_{IF}} [Hz] \tag{3}$$

VF - VG = 0,6V Dreiecksspannungshub

VD = 1,26V (Band-Gap Spannung)

$R_{I/F}$:   Widerstand am Anschluß I/F
$f_{VCO}$:   Frequenz des spannungsgesteuerten Oszillators

Eine Einstellung der Frequenz ist über die Anschlüsse IREG und OPTO am Schaltkreis FCI durchführbar.

Der Stromspiegel Q208, Q209 spiegelt im Kollektor von Q208 den aus den Anschlüssen IREG oder OPTO fließenden Strom so in den Stromspiegel Q200 ... Q204, daß sich der Strom von Kollektor Q208 und Q70 subtraktiv überlagern. Erreicht der Wert des Stromes von Kollektor Q208 im Betrag den Wert des Stromes von Kollektor Q70, wird der Stromspiegel Q200 ... Q204 stromlos und die Frequenz am Anschluß VCO ist Null. Folgender Zusammenhang ist dabei gegeben:

$$t1_{opto/ireg} = \frac{C_{VCO} \cdot 0.6}{\dfrac{1.26}{R_{IF} \cdot 2} - I_{opto} - I_{opto}} \, [s] \tag{4}$$

$$t2_{opto/ireg} = \frac{C_{VCO} \cdot 0.6}{\left(\dfrac{1.26}{R_{IF} \cdot 2} - I_{opto} - I_{opto}\right) \cdot 0.774} \, [s] \tag{5}$$

$$f_{VCOopto/ireg} = \frac{1}{t1_{opto/ireg} + t2_{opto/ireg}} \tag{6}$$

$t1_{opto/ireg}$:     Entladezeit des Kondensators CVCO am Anschluß VCO bei Stellung an den Anschlüssen OPTO oder IREG

$t2_{opto/ireg}$:     Aufladezeit des Kondensators CVCO am Anschluß VCO bei Stellung an den Anschlüssen OPTO oder IREG

$f_{VCO\,opto/ireg}$:     Frequenz des VCO bei aktiven Anschlüssen OPTo ODER IREG

Durch diese Art der Frequenzeinstellung ist ein großer Bereich der Frequenzvariation gegeben. In der integrierten Schaltungsausführung ist eine Frequenzvariation von mehr als 1 : 300 realisierbar.

Die Eingänge OPTO und IREG werden am Kollektor des Transistors Q209 zusammengeführt und wirken auf die Frequenzstellung als ODER-Schaltung. Der Eingang OPTO kann beispielsweise eine Kontrollfunktion der Sekundärseite eines Wandlers über einen Optokoppler vornehmen und über den Eingang IREG kann eine Kontrolle des Maximalstromes eines primärseitigen Leistungstransistors vorgenommen werden.

**Patentansprüche**

1. Steuerbarer Oszillator (VCO) mit einer Vergleichseinheit (Q41, Q38) zum Vergleich des seinem Signaleingang zugeführten Spannungspotentials eines Speicherelementes (C1) mit einem ersten sowie einem zweiten Referenzspannungspotential (VF, VG),

   mit einer Steuerstufe (ECL-FF1), die an die Vergleichseinheit (Q41, Q38) angeschaltet ist und von dieser gesteuert über eine Schalteinheit (Q1, Q2) einen Lade- und Entladezyklus festlegt, und
   mit zwei als gesteuerte Stromquellen (Q200, Q3) ausgebildeten Stromspiegeleinheiten zum Laden und zum Entladen des Speicherelementes (C1),
   wobei über einen Eingang der ersten Stromspiegeleinheit ein Stellstrom (Ifx) eingespeist wird und ein erster Ausgang an das Speicherelement (C1) geführt ist und ein zweiter Ausgang auf einen Eingang der zweiten Stromspiegeleinheit geführt ist,
   so daß vom Stellstrom (Ifx) über die erste und zweite Stromspiegeleinheit (Q200, Q203, Q204; Q3, Q10, Q40) die Oszillatorfrequenz gesteuert wird,

   **dadurch gekennzeichnet,**
   daß ein Impedanzwandler (Q42) vorgesehen ist, dessen Eingang mit der Speichereinheit (C1) und dessen Ausgang mit dem Signaleingang der Vergleichseinheit (Q41, Q38) verbunden ist, daß der zweite Ausgang der ersten Stromspiegeleinheit (Q200, Q203, Q204) direkt mit dem Eingang der zweiten Stromspiegeleinheit verbunden ist, deren erster Ausgang über die Schalteinheit (Q1, Q2) auf das Speicherelement (C1) geführt ist und deren zweiter Ausgang mit dem Signaleingang der Vergleichseinheit (Q41, Q38) verbunden ist, wobei der Emitter des Impedanzwandlers (Q42) mit dem Ausgang einer Stromquelle (Q40) verbunden ist, deren Ausgangsstrom proportional zum Stellstrom (Ifx) ist.

2. Schaltungsanordnung nach Anspruch 1,
   **dadurch gekennzeichnet,**
   daß als Stromspiegeleinheit mindestens zwei mit ihren Basisanschlüssen zusammengeschaltete Transistoren (Q200, Q204; Q3, Q40, Q37, Q36) und einer mit diesen Anschlüssen verbundenen Diode (Q203; Q10) vorgesehen ist.

3. Schaltungsanordnung nach einem der vorhergehenden Ansprüche,
**dadurch gekennzeichnet,**
daß die Vergleichseinheit (Q41, Q38) ein aus einem ersten und einem zweiten Komparator gebildeter Fensterkomparator ist.

4. Schaltungsanordnung nach Anspruch 3,
**dadurch gekennzeichnet,**

daß ein erster Impedanzwandler (Q33) vorgesehen ist, an dessen Eingang ein erstes Referenzspannungpotential (VF) anliegt und dessen Ausgang mit einem Referenzspannungseingang des ersten Komparators (Q41) verbunden ist,
daß ein zweiter Impedanzwandler (Q35) vorgesehen ist, an dessen Eingang ein zweites Referenzspannungpotential (VG) anliegt und dessen Ausgang mit einem Referenzspannungseingang des zweiten Komparators (Q38) verbunden ist,
daß die zweite gesteuerte Stromquelle (Q3) zwei weitere Ausgänge aufweist, die jeweils mit einem Ausgang des ersten und zweiten Impedanzwandlers (Q33, Q35) verbunden sind.

5. Schaltungsanordnung nach einem der Ansprüche 3 oder 4,
**dadurch gekennzeichnet,**
daß als Steuerstufe eine bistabile Kippstufe (ECL-FF1) vorgesehen ist, die von den Ausgangssignalen des Fensterkomparators (Q41, Q38) gesteuert wird.

6. Schaltungsanordnung nach Anspruch 5,
**dadurch gekennzeichnet,**
daß eine Pegelanpassungseinheit (LS) vorgesehen ist, über die das Ausgangssignal der bistabilen Kippstufe (ECL-FF1) der Schalteinheit (VCOS) zugeführt wird.

7. Schaltungsanordnung nach einem der vorhergehenden Ansprüche,
**dadurch gekennzeichnet,**
daß eine Stromsubtraktionseinheit (SUB) vorgesehen ist, der ein konstanter Maximalstrom und mindestens ein Steuerstrom zugeführt wird und die an ihrem Ausgang den Stellstrom (Ifx) abgibt.

**Claims**

1. Controllable oscillator (VCO) having a comparison unit (Q41, Q38) for comparing the voltage potential, fed to its signal input, of a storage element (C1) with a first and a second reference voltage potential (VF, VG), having a control stage (ECL-FF1) which is connected to the comparison unit (Q41, Q38) and, under the control of the latter, defines a charging and discharge cycle via a switching unit (Q1, Q2), and

having two current mirror units, designed as controlled current sources (Q200, Q3), for charging and discharging the storage element (C1),
an adjusting current (Ifx) being fed in via an input of the first current mirror unit and a first output being connected to the storage element (C1) and a second output being connected to an input of the second current mirror unit, with the result that the oscillator frequency is controlled by the adjusting current (Ifx) via the first and second current mirror unit (Q200, Q203, Q204; Q3, Q10, Q40),

characterized

in that an impedance converter (Q42) is provided whose input is connected to the storage unit (C1) and whose output is connected to the signal input of the comparison unit (Q41, Q38),
in that the second output of the first current mirror unit (Q200, Q203, Q204) is connected directly to the input of the second current mirror unit, the first output of which is connected to the storage element (C1) via the switching unit (Q1, Q2) and the second output of which is connected to the signal input of the comparison unit (Q41, Q38), the emitter of the impedance converter (Q42) being connected to the output of a current source (Q40) whose output current is proportional to the adjusting current (Ifx).

2. Circuit arrangement according to Claim 1,
characterized
in that the current mirror unit provided comprises at least two transistors (Q200, Q204; Q3, Q40, Q37, Q36), which are interconnected by their base terminals, and one diode (Q203; Q10) connected to said terminals.

3. Circuit arrangement according to one of the preceding claims,
characterized
in that the comparison unit (Q41, Q38) is a window comparator formed from a first and a second comparator.

4. Circuit arrangement according to Claim 3,
characterized

in that a first impedance converter (Q33) is provided, at whose input a first reference voltage potential (VF) is present and whose output is connected to a reference voltage input of the first comparator (Q41),
in that a second impedance converter (Q35) is provided, at whose input a second reference voltage potential (VG) is present and whose output is connected to a reference voltage input of the second comparator (Q38),
in that the second controlled current source (Q3) has two further outputs, which are respectively connected to an output of the first and second impedance converter (Q33, Q35).

5. Circuit arrangement according to either of Claims 3 or 4,
characterized
in that the control stage provided comprises a bistable multivibrator (ECL-FF1) which is controlled by the output signals of the window comparator (Q41, Q38).

6. Circuit arrangement according to Claim 5,
characterized
in that a level adapting unit (LS) is provided, via which the output signal of the bistable multivibrator (ECL-FF1) is fed to the switching unit (VCOS).

7. Circuit arrangement according to one of the preceding claims,
characterized
in that a current subtraction unit (SUB) is provided, to which a constant maximum current and at least one control current are fed and which outputs the adjusting current (Ifx) at its output.


**Revendications**

1. Oscillateur contrôlable (VCO) avec une unité de comparaison (Q41, Q38) pour la comparaison d'un potentiel de tension d'un élément de stockage (C1) appliqué à son entrée avec un premier et un deuxième potentiel de référence (VF, VG),

avec un étage de commande (ECL-FF1), qui est raccordé à l'unité de comparaison (Q41, Q38) et qui, sous le contrôle d'une unité de commutation (Q1, Q2), définit un cycle de charge et de décharge, et
avec deux unités miroir de courant, sous forme de sources de courant (Q200, Q3), pour la charge et la décharge de l'élément de stockage (C1),
un courant de réglage (Ifx) étant injecté par l'intermédiaire d'une entrée de la première unité miroir de courant et une première sortie étant ramenée à l'élément de stockage (C1) et une deuxième sortie étant ramenée à une entrée de la deuxième unité miroir de courant,
de telle sorte la fréquence de l'oscillateur est contrôlée par le courant de réglage (Ifx) par l'intermédiaire de la première et de la deuxième unité miroir de courant (Q200, Q203, Q204; Q3, Q10, Q40)

**caractérisé par le fait**

qu'un transformateur d'impédance (Q42) est prévu, son entrée étant raccordée à l'unité de stockage (C1) et sa sortie étant raccordée à l'entrée de l'unité de comparaison (Q41, Q38),
que la deuxième sortie de la première unité miroir de courant (Q200, Q203, Q204) est raccordée directement à l'entrée de la deuxième unité miroir de courant, dont la première sortie est ramenée, par l'intermédiaire de l'unité de commutation (Q1, Q2) à l'élément de stockage (C1) et dont la deuxième sortie est raccordée à l'entrée de l'unité de comparaison (Q41, Q38), l'émetteur du transformateur d'impédance (Q42) étant raccordé à la sortie d'une source de courant (Q40) dont le courant de sortie est proportionnel au courant de réglage (Ifx).

2. Montage selon la revendication 1,
   **caractérisé par le fait**
   que, en tant qu'unité miroir de courant, sont prévus au moins deux transistors reliés par leurs bases (Q200, Q204; Q3, Q40, Q37, Q36) et une diode (Q203; Q10) raccordée à ces bases.

3. Montage selon une des revendications précédentes
   **caractérisé par le fait**
   que l'unité de comparaison (Q41, Q38) est un comparateur à fenêtre constitué d'un premier et d'un deuxième comparateur.

4. Montage selon la revendication 3
   **caractérisé par le fait**

   qu'un premier transformateur d'impédance (Q33) est prévu, un premier potentiel de tension de référence (VF) étant appliqué à son entrée et sa sortie étant raccordée à une entrée de tension de référence du premier comparateur (Q41),
   qu'un deuxième transformateur d'impédance (Q35) est prévu, un deuxième potentiel de tension de référence (VG) étant appliqué à son entrée et sa sortie étant raccordée à une entrée de tension de référence du deuxième comparateur (Q38),
   que la deuxième source de courant contrôlée (Q3) comporte deux autres sorties qui sont raccordées chacune à une sortie du premier et du deuxième transformateur d'impédance (Q33, Q35).

5. Montage selon une des revendications 3 ou 4
   **caractérisé par le fait**
   que, en tant qu'étage de commande, une bascule bistable (ECL-FF1) est prévue, laquelle est contrôlée par les signaux de sortie du comparateur à fenêtre (Q41, Q38).

6. Montage selon la revendication 5
   **caractérisé par le fait**
   qu'une unité d'adaptation de niveau (LS) est prévue par l'intermédiaire de laquelle le signal de sortie de la bascule bistable (ECL-FF1) est appliquée à l'unité de commutation (VCOS).

7. Montage selon une des revendications précédentes
   **caractérisé par le fait**
   qu'une unité de soustraction de courant (SUB) est prévue, sur laquelle sont amenés un courant constant maximum et au moins un courant de contrôle et qui délivre, à sa sortie, un courant de réglage (Ifx).

**FIG 1**

EP 0 788 681 B1

FIG 2

FIG 3

EP 0 788 681 B1

**FIG 4**

EP 0 788 681 B1